# EUROPÄISCHE PATENTANMELDUNG

(11) **EP 0 961 429 A2**
(43) Veröffentlichungstag der Anmeldung: **01.12.1999**
(21) Anmeldenummer: 99109974.8
(22) Anmeldetag: 21.05.1999
(51) Int. Cl.: H04H 1/00, H04B 1/16

(54) **Verfahren und Einrichtung zur Anzeige der einer Funktionstaste aktuell zugeordneten Funktion in einem Audiogerät in einem Kraftfahrzeug, wie zum Beispiel einem Rundfunkempfänger**

(30) Priorität: 26.05.1998 DE 19823315
(71) Anmelder: Volkswagen Aktiengesellschaft, 38436 Wolfsburg (DE)
(72) Erfinder: Hermann, Holger Dipl.-Phys., 38165 Lehre (DE); Kiesewetter, Thomas, 38118 Braunschweig (DE); Schönemann, Otto, 38444 Wolfsburg (DE); Richter, Thorsten, 38165 Flechtorf (DE)

(57) **Zusammenfassung**

Die Erfindung betrifft ein Verfahren sowie eine Einrichtung zum Betrieb eines Audiogerätes, insbesondere eines mobilen Audiogerätes bei einem Kraftfahrzeug ggf. ein RDS-gestütztes Rundfunkgerät, bei welchem verschiedene Programmspeicher oder Funktionen und/oder Betriebsarten durch Funktionstasten wählbar sind und auf einem Display angezeigt werden. Um bei einem Verfahren sowie einer Einrichtung dieser Art eine Verbesserung im Hinblick auf effiziente Visualisierung und bessere Zuordnung der Funktionstasten zur einfacheren Bedienung zu gewährleisten ist erfindungsgemäß vorgeschlagen, daß zu jeder Funktionstaste jeweils ein örtlich der jeweiligen Funktionstaste direkt benachbartes Display oder Displaysegment zur Anzeige vorgesehen ist, und daß dieses Display oder Displaysegment der jeweiligen Funktionstaste aktuell zugeordnete Funktion mit einem Symbol oder einem Kürzel anzeigt.

## Beschreibung

Die Erfindung betrifft ein Verfahren und eine Einrichtung zum Betrieb eines Audiogerätes, insbesondere eines mobilen Audiogeräts bei einem Kraftfahrzeug, ggf. ein RDS-gestütztes Rundfunkgerät, bei welchem verschiedene Programmspeicher und/oder Funktionen und/oder Betriebsarten durch Funktionstasten wählbar sind und auf einem Display angezeigt werden, gemäß Oberbegriff der Patentansprüche 1 und 7.

Verfahren und Einrichtung zum Betrieb eines Audiogeräts, sprich eines Autoradios bei einem Kraftfahrzeug sind vielfach bekannt. Die Anzeige von senderspezifischen Daten sind dabei von besonderem Interesse. Autoradios der neueren Generation sind mit sogenannten RDS-Empfängem ausgestattet, die Rundfunkdaten empfangen. Diese können beispielsweise darin bestehen, eine Senderkennung oder ein Kürzel für den Namen des jeweiligen Senders sichtbar zu machen, oder wie dies im europäischen Ausland bereits praktiziert wird, kurze durchlaufende Textmitteilungen am Display erscheinen zu lassen. Letzteres ist aus sicherheitstechnischen Gründen umstritten. Die Übersendung einer Senderkennung in Form eines Buchstaben- oder Zahlenkürzels wie beispielsweise NDR 4 oder dergleichen ist jedoch bereits vielfach verbreitet.

Bei stationären Geräten ist es bekannt, senderspezifische Informationen zu übersenden und sodann am Radiogerät oder am Fernsehgerät sichtbar zu machen.

So ist aus der EP 0732821 A 2 ein System bekannt, bei welchem senderspezifische Informationen durch mehrmalige Betätigung von Funktionstasten am Gerät selbst oder an der Fernbedienung abgerufen werden können. Diese Daten werden dann auf dem Bildschirm des Fernsehgerätes oder des Radiogerätes sichtbar gemacht. Dieses System betrifft ausschließlich stationäre Anlagen.

Aus der WO 97/06612 bzw. aus der dazugehörigen Prioritätsanmeldung DE 195-290 75 A 1 ist ein System bekannt, bei dem schrittweise Maßnahmen ausgelöst werden. Als erstes wird zunächst das Auffinden eines Senders generiert Dieser Vorgang ist im allgemeinen mit Sendersuchlauf bezeichnet. Ist ein Sender gefunden, so wird dann als erstes die Programmart angezeigt. Zeitverzögert, d.h. automatisch zeitverzögert erscheint dann der Sendername bzw. die Kurzform des Senders. Die Anzeige der Programmart und die Anzeige der Sendererkennung dann dabei beispielsweise periodisch im Wechsel generiert werden.

Für den mobilen Einsatz, d.h. den Einsatz beispielsweise bei einem Autoradio sind neben der reinen Senderwahl auch Sender von Bedeutung, die Verkehrsfunkmeldungen durchgeben. Solche Verkehrsfunksender übermitteln einen speziellen Code, der beispielsweise den CD- oder Kassettenbetrieb der Autoaudioanlage stummschaltet und die Verkehrsmeldung durchsteuert. Hierzu ist aus der DE 195 10 219 A1 ein Aufzeichnungsgerät für eine solche Audioanlage für Kraftfahrzeuge bekannt, welches keine Stummschaltung vornimmt, sondern die Verkehrsfunksendungen aufzeichnet. Diese können dann auf Wunsch und per Knopfdruck abgerufen werden.

Weiterhin ist von besonderem Interesse, die Pegel der einzeln abgespeicherten Sender bzw. Sendestationen ermitteln und aktualisieren zu können. Dies hat besondere Bedeutung auf längeren Fahrstrecken, auf welchen man ggf. die Sendebereiche jeweiliger Sendestationen verläßt. In solchen Fällen muß der Fahrzeugführer oftmals eine Neuprogrammierung bzw. eine Neuabspeicherung der nunmehr aktuellen Sender des neuen Gebietes vornehmen. So ist der DE 38 44 929 C 2 eine Umschaltung der Senderkennung bei RDS-Empfänger bekannt, die automatisch eine Umschaltung von der Darstellung der Senderkennung auf die Frequenz vornimmt, sobald ein Senderpegel unterhalb eines Mindestpegels abgesunken ist. Die Umschaltung von Senderkennung auf Frequenz signalisiert dem Fahrzeugführer, daß er für diesen Sender derzeit keinen ausreichend guten Empfang mehr hat und er eine Neueinstellung vorzunehmen hat.

Die Bedienung der Audioanlage, insbesondere des Radiogerätes während der Fahrt bedingt besondere Sicherheitsaspekte zu beachten. Zum einen ist die Aktualisierung auf den jeweils aktuell geltenden und erreichbaren Verkehrsfunksender besonders bei Langstreckenfahrten von großer Bedeutung. Andererseits darf der Fahrer nicht übermäßig vom Verkehrsgeschehen durch die Notwendigkeit einer Bedienung seines Radiogerät abgelenkt werden.

Der Erfindung liegt somit die Aufgabe zu Grunde, sowohl hinsichtlich eines Verfahrens zum Betrieb eines Audiogeräts sowie auch einer Rundfunkempfangseinrichtung der gattungsgemäßen Art, eine Verbesserung im Hinblick auf effiziente Visualisierung und bessere Zuordnung der Funktionstasten zur einfacheren Bedienung zu gewährleisten.

Die gestellte Aufgabe ist bei einem Verfahren der gattungsgemäßen Art erfindungsgemäß durch die kennzeichnenden Merkmale des Patentanspruches 1 gelöst.

Weitere vorteilhafte Ausgestaltungen des erfindungsgemäßen Verfahrens sind in den Ansprüchen 2 bis 6 angegeben.

Hinsichtlich einer Einrichtung der gattungsgemäßen Art ist die gestellte Aufgabe durch die kennzeichenden Merkmale des Patentanspruches 7 gelöst. Weitere vorteilhafte Ausgestaltungen der erfindungsgemäßen Einrichtung sind in den übrigen abhängigen Ansprüchen angegeben.

Der Kerngedanke der Erfindung steht darin bei einer Mehrzahl von Funktionstasten jeweils ein örtlich der jeweiligen Funktionstaste direkt benachbartes Display und Displaysegment vorzusehen, wobei dann dieses Display oder Displaysegment die der jeweiligen Funktionstaste aktuell zugeordneten Funktion mit einem Symbol oder einem Kürzel anzeigt.

Hierbei können die Kürzel entweder, beispielsweise beim obigen Radiobetrieb aus der Anordnung der den einzelnen Funkionstasten zugeordneten Senderstationskürzeln sein, oder aber anderweitige Funktionszuweisungen.

Auf diese Weise wird im erstgenannten Fall jeder Funktionstaste, der jeweils ein Sender zugeordnet ist, die entsprechende Senderkennung direkt benachbart angezeigt werden. Da entweder jeder Funktionstaste ein eigenes Display oder zumindest jeder Funktionstaste ein Displaysegment des gesamten Displays zugeordnet ist, ist es nun möglich, jede Funktionstaste, d.h. neben oder über jeder Funktionstaste, diejenige Senderkennung erscheinen zu lassen, welche durch die jeweilige Funktionstaste hinterlegt ist. D.h. der Fahrzeugführer kann auf einfache Weise durch Einsichtnahme des Displays insgesamt erkennen, hinter welcher Funktionstaste beispielsweise ein Sender wie NDR 2, oder NDR 1 oder Antenne oder FFN abrufbar ist. Das heißt der Fahrzeugführer braucht nicht mehr durch langwieriges Ausprobieren herausfinden hinter welcher Funktionstaste welcher Sender verborgen ist. Dabei wird jeder Funktionstaste zu jeder Zeit die entsprechende Anzeige kenntlich gemacht, so daß der Fahrzeugführer auf einen Blick alle abgespeicherten Sender bzw. deren Senderkürzel oder Senderkennungen ablesen kann. Die Wahl des gewünschten Senders erfolgt dann durch einfachen Knopfdruck und nicht mehr durch Ausprobieren wie dies im Stand der Technik oftmals notwendig ist.

Erfindungsgemäß können über einen Wahlschalter den Funktionstasten aber auch andere Funktionen zugewiesen werden beispielsweise eine Regelfunktion des Tuningsystems der Audioanlage, oder für den CD-Betrieb oder den Kassettenbetrieb eine entsprechende Anzeige mit entsprechender Funktionszuweisung zu den Tasten.

Im oben genannten Fall kann eine Wahlschalterbetätigung auch einfach darin bestehen zwischen Frequenzanzeige und Senderkennungsanzeige hin und her schalten zu können.

Eine erfindungsgemäße Ausgestaltung besteht darin, daß eine beispielsweise Drehknopfbetätigung zur Senderwahl bzw. zum handbetätigten Sendersuchen bewirkt, daß für die Dauer der besagten Drehknopfbetätigung eine Frequenzbandlinie angezeigt wird. Dabei wird auch angezeigt, wo aktuell der gerade erreichte Frequenzwert steht.

Bei einer Einrichtung der gattungsgemäßen Art besteht die erfindungsgemäße Grundausführung darin, daß bei einer Mehrzahl von Funktionstasten ein Display an jeder einzelnen Funktionstaste oder bei einem zusammenhängenden Display ein jeweilig einer Funktionstaste zugeordnetes Displaysegment vorgesehen ist, welches der jeweiligen Funktionstaste benachbart angeordnet ist. Somit ist die räumliche Zuordnung des entsprechenden Displays oder des Displaysegmentes zu der entsprechenden Funktionstaste eindeutig.

Es kann dabei auch vorteilhaft sein, die Funktionstasten aneinanderzureihen und darüber oder daneben ein gemeinsames zusammenhängendes Display anzuordnen, welches segmentiert ist. So hat dann jede Funktionstaste in seiner direkten Angrenzung bzw. Nachbarschaft ein Display oder Displaysegment auf welchem die entsprechenden Funktionsdaten der jeweiligen Funktionstaste angezeigt werden.

Es kann dabei auch sein, daß die Funktionstasten auf einem größeren Audiobedienpanel verschiedentlich gruppiert sind. Das heißt beispielsweise eine Gruppe von drei Funktionstasten ist an einem Ort und eine Gruppe von weiteren fünf Funktionstasten ist woanders plaziert. Dann sollten natürlich die Funktionstasten entweder um ein gemeinsames größeres Display mit jeweilig örtlich zugeordneten Displaysegmenten angeordnet sein, oder es sollten zwei oder mehrere Einzeldisplays vorgesehen sein.

Die Erfindung ist in der Zeichnung dargestellt und nachfolgend näher beschrieben.

Es zeigt
- Figur 1:: Anzeige für Senderkennung.
- Figur 2:: Anzeige für Frequenz mit und ohne Scan.
- Figur 3:: Umschaltung des Displays auf Tuner- bzw. Verstärkerfunktionen.
- Figur 4:: Display mit Kanalpegel bei CD-Betrieb.
- Figur 5:: Display mit CD-Anzeige in Einzeltiteln.
- Figur 6:: Funktionszuweisung unterschiedlicher Wellenlängenbereiche.

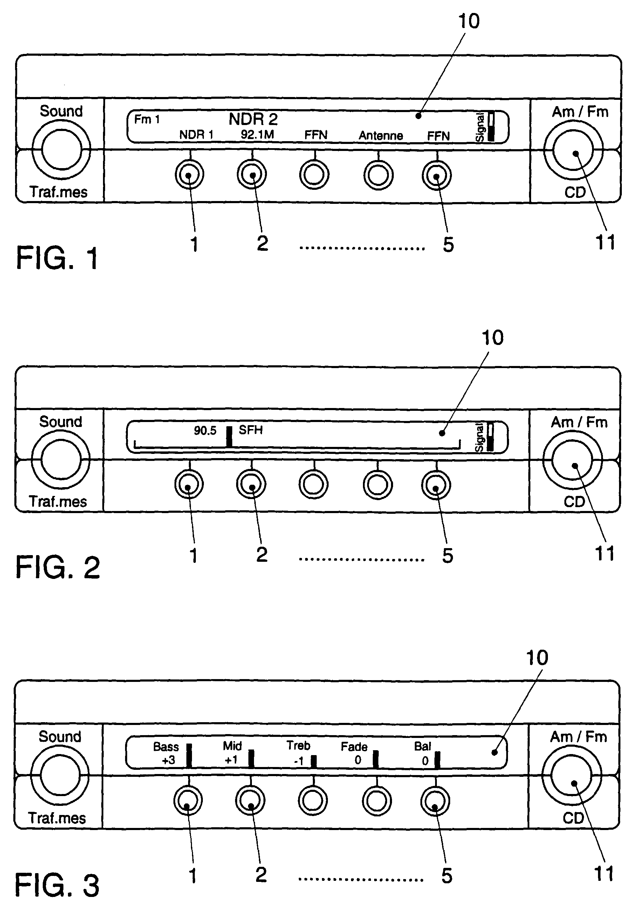

Figur 1 zeigt eine erste Möglichkeit im Falle des Radiobetriebes bei welchem den einzelnen Funktionstasten 1 bis 5 durch eine zuvor gewählte Suchlauf- und Speicherfunktion verschiedene Sender eingestellt und abgespeichert sind. Die jeweils abgespeicherten Sender sind in diesem Falle auf dem Display 10 klein dargestellt in der Nähe jeder jeweiligen Funktionstaste 1 bis 5 plaziert. Der aktuell gewählte Sender wird dadurch kenntlich gemacht, indem die Senderkennung deutlich vergrößert dargestellt wird und zusätzlich noch die Frequenz, so wie dies in Fig. 1 dargestellt ist.

Figur 2 zeigt lediglich die Frequenz und die der erreichbaren Frequenz zugeordnete Senderkennung. Dieser Zustand wird gegenüber Figur 1 dadurch erreicht, daß beispielsweise der Wahlschalter 11 lediglich gedrückt wird und ein Scannen durch den Tuner erfolgt. Der Scannvorgang wird dabei auf dem Display 10 dargestellt und jedes Mal wenn ein Mindestpegel erreicht ist, wird die zugehörige Frequenz und der Sender dargestellt und sodann die verfügbaren Sender insgesamt auf die Funktionstasten 1 bis 5 verteilt zugeordnet und abgespeichert.

Figur 3 zeigt einen Betriebsmodus der durch Betätigen des Wahlschalters 11 generiert wird, in dem beispielsweise die Verstärkerfunktionen wie Bass, Höhen, Ballance etc. auf dem Display 10 dargestellt werden. Hierbei erfolgt nicht nur eine Darstellung der besagten Parameter auf dem Display sondern es sind dieselben den einzelnen Funktionstasten 1 bis 5 zugeordnet, so daß durch deren Betätigung die Werte der jeweiligen Parameter verändert werden kann. Dabei ist die entsprechende Funktion mit einem Buchstabenkürzel benannt und auf die gleiche Weise so im Display 10 plaziert, daß sie in der Nähe der jeweils zugehörigen Funktionstaste angezeigt wird.

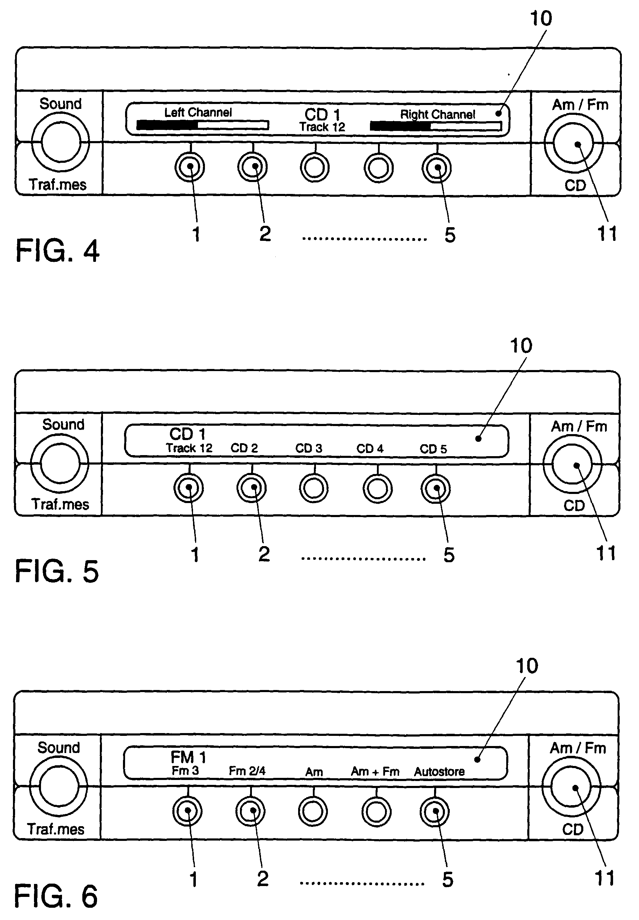

Figur 4 zeigt eine weitere Umschaltmöglichkeit, die beispielsweise die Kanaldarstellung für die Lautsprecher wiedergibt bei beispielsweise hochqualitativen Wiedergaben durch CD oder Musikcassette.

Figur 5 zeigte eine Darstellung die auch den Wahlschalter 11 erreichbar ist, und beim CD-Betrieb ebenfalls generiert werden kann. Hierbei wird zum einen auf dem Display 10 dargestellt, daß der CD-Betrieb generiert ist und zum anderen werden den einzelnen Titeln oder den jeweiligen CDs fortlaufend steigend, die jeweiligen Funktionstasten 1 bis 5 zugeordnet, so daß über die Funktionstasten eine Titelwahl oder bei CD-Wechslern eine CD-Wahl erfolgen kann.

Figur 6 zeigt einen Funktionsmodus, der ebenfalls durch Betätigung des Wahlschalters 11 erreicht werden kann, indem jeder Funktionstaste 1 bis 5 entweder die einzelnen Wellenlängenbereiche oder Scan- bzw. automatische Speicherfunktion zugeordnet werden kann. Insgesamt ist jeder Funktionstaste 1 bis 5 in jedem der Betriebsmodi entweder durch ein Kürzel die jeweilige Funktion oder durch ein Kürzel in Form der Senderkennung derjeweilige Speicherinhalt derjeweiligen Funktionstaste dargestellt.

Durch Betätigen des Wahlschalters 11 wird jeweilig auch angezeigt, in welchem Betriebsmodus das Gerät sich gerade befindet und welche Funktionen die Funktionstasten aktuell haben. Auf diese Weise ist eine einfachere Gestaltung des Bedienpanels von Autoaudioanlagen möglich, was einen hohen Sicherheitsstandard erfüllt. Der Fahrer kann durch Betätigung weniger Tasten sein Gerät optimal bedienen und wird somit nicht vom aktuellen Straßenverkehr abgelenkt.

Dabei kann wie oben bereits ausgeführt, der Wahlschalter 11 so ausgelegt sein, daß eine Tippbetätigung die einzelnen Funktionen gemäß Fig. 1 bis 6 generiert und eine Drehbetätigung einen herkömmlichen manuellen Senderlauf generiert, bei welchem auch die Bandbreitenlinie mit den einzelnen Frequenzen am Display 10 eingeblendet wird.

## Patentansprüche

1. Verfahren zum Betrieb eines Audiogerätes insbesondere eines mobilen Audiogerätes bei einem Kraftfahrzeug, ggf. ein RDS-gestütztes Rundfunkgerät bei welchem verschiedene Programmspeicher und/oder Funktionen und/oder Betriebsarten durch Funktionstasten wählbar sind und auf einem Display angezeigt werden,
dadurch gekennzeichnet,
daß zu jeder Funktionstasten jeweils ein örtlich der jeweiligen Funktionstaste direkt benachbartes Display oder Displaysegment zur Anzeige vorgesehen ist, und daß dieses Display oder Displaysegment, die der jeweiligen Funktionstaste aktuell zugeordnete Funktion mit einem Symbol oder Kürzel anzeigt.

2. Verfahren zum Betrieb eines Audiogeräts nach Anspruch 1,
dadurch gekennzeichnet,
daß über einen Wahlschalter die den Funktionstasten zugewiesene Funktionen verändert und entsprechend zur Anzeige gebracht werden.

3. Verfahren zum Betrieb eines Audiogeräts nach Anspruch 2,
dadurch gekennzeichnet,
daß über die Wahlschalterbetätigung zwischen Frequenzanzeige und Senderkennungsanzeige (RDS) geschaltet werden kann.

4. Verfahren zum Betrieb eines Audiogeräts nach Anspruch 2 oder 3,
dadurch gekennzeichnet,
daß den Funktionstasten durch Wahlschalterbetätigung akustische verstärkertechnische Einstellfunktionen wie Bässe, Höhen, Ballance etc. zugeordnet werden können.

5. Verfahren zum Betrieb eines Audiogeräts nach Anspruch 2 oder 3,
dadurch gekennzeichnet,
daß den Funktionstasten durch Wahlschalterbetätigung verstärkertechnische Einstellfunktionen für andere mitangeschlossene Tonträger wie Cassette und CD zugeordnet werden können.

6. Verfahren zum Betrieb eines Audiogeräts nach einem oder mehreren der vorhergehenden Ansprüche,
dadurch gekennzeichnet,
daß durch Betätigen eines Drehschalters im Display die verfügbare Bandbreite und der jeweils durch Drehbetätigung manuell erreichte Sender bzw. die entsprechende Frequenzzahl angezeigt wird.

7. Einrichtung zum Betrieb eines Audiogerätes bzw. ein Audiogerät selbst, insbesondere eines mobilen Audiogerätes bei einem Kraftfahrzeug, ggf. ein RDS gestütztes Rundfunkgerät bei welchem verschiedene Programmspeicher und/oder Funktionen und/oder Betriebsarten durch Funktionstasten wählbar sind und auf einem weiterhin angeordneten Display anzeigbar sind,
dadurch gekennzeichnet,
daß eine Mehrzahl von Funktionstasten (1,2,...) vorgesehen sind, und daß das Display oder die Displaysegmente (10) so angeordnet sind, daß jeweils ein Display oder ein Displaysegment jeweils jedem der besagten Funktionstasten räumlich benachbart angeordnet ist.

8. Einrichtung zum Betrieb eines Audiogerätes nach Anspruch 7,
dadurch gekennzeichnet,
daß ein zusammenhängendes Display (10) vorgesehen ist, daß die Funktionstasten (1,2,...) neben diesem Display angeordnet sind, derart, daß jeder Funktionstaste jeweils ein Displaysegment zugeordnet ist.

9. Einrichtung zum Betrieb eines Audiogeräts nach Anspruch 7 oder 8,
dadurch gekennzeichnet,
daß ein Wahlschalter (11) vorgesehen ist, über welchen zum einen die Funktionszuweisung der Funktionen veränderbar einstellbar ist und zum anderen die jeweilig aktuelle Funktion der jeweiligen Funktionstaste (1,2,...) auf dem jeweilig zugeordneten Displaysegment anzeigbar ist.
